# EUROPÄISCHE PATENTSCHRIFT

(11) **EP 3 360 158 B1**
(45) Veröffentlichungstag und Bekanntmachung des Hinweises auf die Patenterteilung: **13.01.2021**
(21) Anmeldenummer: 16774965.4
(22) Anmeldetag: 04.10.2016
(51) Int. Cl.: C04B 37/02, H01L 23/00, H01L 23/36, H01L 23/367, H01L 23/373, H01L 23/498, H01L 25/07, H01L 23/467, H01L 23/473

(54) **ZWEISEITIG GEKÜHLTER SCHALTKREIS**
CIRCUIT COOLED ON TWO-SIDES
CIRCUIT DE COMMUTATION REFROIDI DES DEUX CÔTÉS

(30) Priorität: 07.10.2015 DE 102015219347
(43) Veröffentlichungstag der Anmeldung: 15.08.2018
(73) Patentinhaber: CeramTec GmbH, 73207 Plochingen (DE)
(72) Erfinder: DILSCH, Roland, 95199 Thierstein (DE); KRESS, Harald, 90579 Langenzenn (DE)
(86) Internationale Anmeldenummer: PCT/EP2016/073643
(87) Internationale Veröffentlichungsnummer: WO 2017/060224

(56) Entgegenhaltungen:
- EP-A1- 2 892 074
- US-A1- 2013 075 932
- US-B1- 7 049 695

## Beschreibung

Die Erfindung betrifft ein Bauteil bestehend aus einem ersten keramischen Substrat mit einer Ober- und Unterseite, wobei auf der Oberseite eine Metallisierung aufgebracht ist, auf der über ein Verbindungsmittel ein elektronisches Bauelement mit seiner Unterseite montiert ist.

Es ist bekannt, dass keramische Substrate aus Al203 oder AIN eine mindestens einseitige Metallisierung (DCB-Cu, Dickfilm-Cu, Ag, W-Ni-Au) tragen, auf der wiederum fixiert durch Druck, Lot, gesintertes Silber, Silberkleber o.ä. ein Si-Schaltkreis montiert ist.

Auf der zweiten Seite des Substrats können weitere Metallisierungsflächen vorhanden sein, auf die beispielsweise ein Kühlkörper aus Aluminium o.ä. geklebt oder gelötet ist. Die Si-Schaltkreise sind also maximal einseitig mit einer elektrisch isolierenden Wärmesenke verbunden. Die obere freie Seite des Si-Schaltkreises wird höchstens gasgekühlt. Unter einem Si-Schaltkreis wird ganz allgemein auch ein Chip oder ein Transistor verstanden.

US2013/0075932 offenbart ein Leistungshalbleitermodul mit integrierter Dickschichtleiterplatte.

Der Erfindung liegt die Aufgabe zugrunde, ein Bauteil nach dem Oberbegriff des Anspruchs 1 so zu verbessern, dass der Si-Schaltkreis beidseitig, d.h. sowohl auf seiner Unter- als auch auf seiner Oberseite gekühlt wird. Die doppelseitige Kühlung der Si-Schaltkreise durch Elemente mit hoher Wärmeleitfähigkeit und gleichzeitiger hoher elektrischer Leitfähigkeit soll die Effizienz der Baugruppe steigern.

Erfindungsgemäß wird diese Aufgabe durch ein Bauteil mit den Merkmalen des Anspruchs 1 gelöst.

Dadurch, dass auf der Oberseite Si-Schaltkreises ein Verbindungsmittel aufgebracht ist auf dem ein keramisches Flachsubstrat mit seiner Unterseite aufgebracht ist und auf dem Flachsubstrat über eine Metallisierung ein zweites keramisches Substrat angeordnet ist, wobei das keramische Flachsubstrat metallgefüllte thermisch-elektrische Durchkontaktierungen (Vias) und/oder Kühlkanäle zur Führung eines Kühlmittels enthält, wird der Si-Schaltkreis beidseitig, d.h. sowohl auf seiner Unterals auch auf seiner Oberseite gekühlt. Die doppelseitige Kühlung des Si-Schaltkreises durch Elemente mit hoher Wärmeleitfähigkeit und gleichzeitiger hoher elektrischer Leitfähigkeit soll die Effizienz der Baugruppe des Si-Schaltkreises steigern. Das Metall in den Vias des keramischen Flachsubstrats liegt dabei sowohl auf der Metallisierung des zweiten Substrats als auch auf dem Verbindungsmittel auf, welches sich auf dem Si-Schaltkreis befindet.

Der Si-Schaltkreis ist bevorzugt ein Chip oder ein Transistor.

Die Metallisierungen bestehen bevorzugt aus DCB-Cu, Dickfilm-Cu, Ag oder W-Ni-Au und/oder sind mit dem keramischen Substrat versinterte Metallisierungen. Versinterte Metallisierungen sind innig mit der Keramik verbunden und haben dadurch einen exzellenten Wärmetransport vom Si-Schaltkreis in die Keramik.

Das Verbindungsmittel ist bevorzugt ein Lot, gesintertes Silber oder Silberkleber.

In der Erfindung bestehen die Durchkontaktierungen aus Cu und die Substrate aus Aluminiumnitrid. Aluminiumnitrid hat eine hohe Wärmeleitfähigkeit.

Auf der Unterseite des ersten keramischen Substrats sind in einer Ausführungsform Kühlelemente, wie Finnen oder ähnliches angeordnet.

Mit Hilfe des keramischen Flachsubstrats mit metallgefüllten Vias welches die freie Oberseite des Si-Schaltkreises über das Verbindungsmitttel berührt kann eine bessere doppelseitige Wärmeabfuhr erfolgen. Dieses Flachsubstrat enthält metallgefüllte thermisch-elektrische Durchkontaktierungen (Vias), gefüllt mit Cu. Wählt man Aluminiumnitrid als Substratwerkstoff, ist dessen Ausdehnungskoeffizient von ca. 4, 7 ppm/K nahe am Silicium des Chips mit ca. 4,2 ppm/K.

Die Anbindung dieser Viakeramik (Flachsubstrats) kann sowohl auf der Seite des Si-Schaltkreises wie auch auf der anderen Seite des metallisierten keramischen Substrats über Lot, Silberpaste oder Silbersinterschicht an ein zweites keramisches Substrat erfolgen oder aber beim Einbrennen der Kupferpaste direkt mit der Kupferschicht des metallisierten oberen Substrates verbinden.

Zur weiteren Erhöhung der Wärmeableitung können anstelle der keramischen Flachsubstrate auch flüssigkeitsdurchströmte keramische Kühler oder solche mit keramischen Finnen verwendet werden.

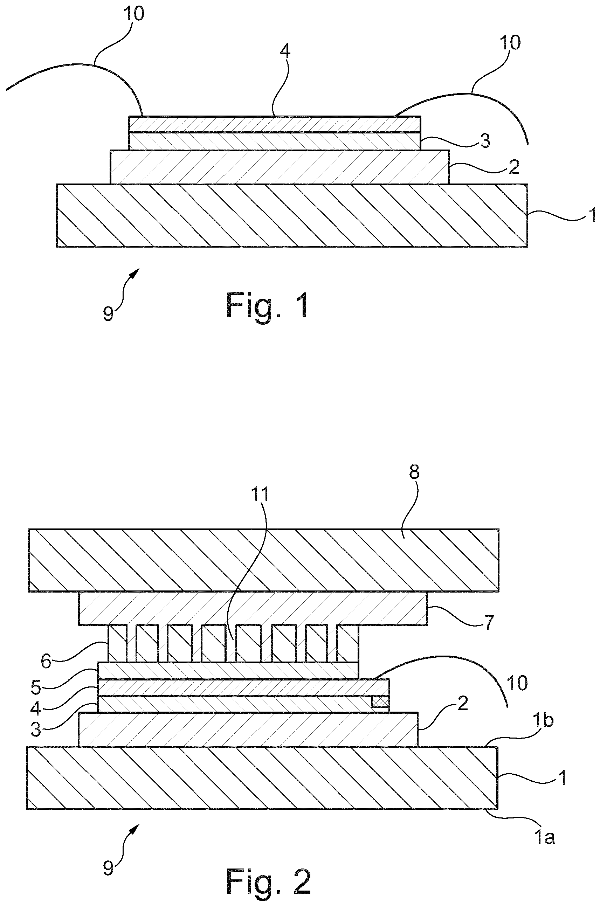

Die Figuren zeigen den Stand der Technik (Figur 1) und ein erfindungsgemäßes Bauteil (Figur 2).

Figur 1 zeigt ein Bauteil 9 nach dem Stand der Technik. Das Bauteil besteht aus einem ersten keramischen Substrat 1 mit einer Ober- 1b und Unterseite 1a, wobei auf der Oberseite 1b eine Metallisierung 2 aufgebracht ist, auf der über ein Verbindungsmittel 3 ein Si-Schaltkreis 4 mit seiner Unterseite montiert ist. Auf dem Si-Schaltkreis 4 bzw. auf seiner Oberseite ist erfindungsgemäß über ein Verbindungsmittel 5 ein keramisches Flachsubstrat 6 mit seiner Unterseite aufgebracht und ist auf dem Flachsubstrat 6 über eine Metallisierung 7 ein zweites keramisches Substrat 8 angeordnet, wobei das keramische Flachsubstrat 6 metallgefüllte thermisch-elektrische Durchkontaktierungen (Vias) 11 und/oder Kühlkanäle zur Führung eines Kühlmittels enthält.

Die keramischen Substrate 1, 8 sind bevorzugt plattenförmig ausgebildet und bestehen aus Aluminiumnitrid, welches eine sehr hohe thermische Leitfähigkeit hat.

Die Metallisierungen bestehen bevorzugt aus DCB-Cu, Dickfilm-Cu, Ag oder W-Ni-Au und/oder sind mit dem keramischen Substrat 1, 8 versintert.

Der SI-Schaltkreis 4 ist ein Silizium-Schaltkreis in der Ausführung eines Chips oder eines Transistors.

Die Verbindungsmittel 3, 5 sind bevorzugt Lot, gesintertes Silber oder Silberkleber.

Die Durchkontaktierungen 11 bestehen aus Cu.

Auf der Unterseite 1a des ersten keramischen Substrats 1 sind bevorzugt Kühlelemente angeordnet, in Figur 2 nicht gezeigt. Diese Kühlelemente können zur Luftkühlung Finnen sein. Es können aber auch flüssigkeitsführende Kühlboxen sein. Das keramische Flachsubstrat 6 dient zur Ableitung der Abwärme des SI-Schaltkreises 4 in das keramische Substrat 8 und kann andererseits auch zur elektrischen Ankopplung des SI-Schaltkreises 4 an die Metallisierung 7 genutzt werden. Auch das Flachsubstrat 6 besteht aus Aluminiumnitrid. Durch seine metallgefüllten thermisch-elektrischen Durchkontaktierungen (Vias) 11 wird die Abwärme transportiert und eine elektrische Verbindung hergestellt. Bevorzugt verlaufen die Durchkontaktierungen (Vias) 11 rechtwinklig zur Oberfläche des Flachsubstrats 6.

Mit dem Bezugszeichen 10 sind in beiden Figuren Bonddrähte zur elektrischen Anbindung gekennzeichnet.

## Patentansprüche

1. Bauteil (9) bestehend aus einem ersten keramischen Substrat (1) mit einer Ober- (1b) und Unterseite (1a), wobei auf der Oberseite (1b) eine Metallisierung (2) aufgebracht ist, auf der über ein Verbindungsmittel (3) ein Si-Schaltkreis (4) mit seiner Unterseite montiert ist, wobei auf der Oberseite des Si-Schaltkreises (4) ein Verbindungsmittel (5) aufgebracht ist auf dem ein keramisches Flachsubstrat (6) mit seiner Unterseite aufgebracht ist und auf dem Flachsubstrat (6) über eine Metallisierung (7) ein zweites keramisches Substrat (8) angeordnet ist und das keramische Flachsubstrat (6) metallgefüllte thermisch-elektrische Durchkontaktierungen (Vias) (11) enthält, **dadurch gekennzeichnet, dass** die metallgefüllten thermisch-elektrischen Durchkontaktierungen (Vias) (11) mit Cu gefüllt sind und das keramische Flachsubstrat (6) Aluminiumnitrid ist.

2. Schaltkreis nach Anspruch 1, **dadurch gekennzeichnet, dass** der SI-Schaltkreis (4) ein Silizium-Schaltkreis, ein Chip oder ein Transistor ist.

3. Schaltkreis nach Anspruch 1 oder 2, **dadurch gekennzeichnet, dass** alle Metallisierungen (2, 7) aus DCB-Cu, Dickfilm-Cu, Ag oder W-Ni-Au bestehen und/oder mit dem keramischen Substrat (1, 8) versinterte Metallisierungen sind.

4. Schaltkreis nach einem der Ansprüche 1 bis 3, **dadurch gekennzeichnet, dass** das Verbindungsmittel (3, 5) Lot, gesintertes Silber oder Silberkleber sind.

5. Schaltkreis nach einem der Ansprüche 1 bis 5, **dadurch gekennzeichnet, dass** auf der Unterseite (1a) des ersten keramischen Substrats (1) Kühlelemente angeordnet sind.

## Claims

1. Component (9) consisting of a first ceramic substrate (1) having an upper face (1b) and a lower face (1a), a metallization (2) being applied to the upper face (1b), on which metallization the lower face of a Si circuit (4) is mounted by means of a connecting means (3), a connecting means (5) being applied to the upper face of the Si circuit (4), on which connecting means the lower face of a ceramic flat substrate (6) is applied, and a second ceramic substrate (8) being arranged on the flat substrate (6) via a metallization (7) and the ceramic flat substrate (6) containing metal-filled thermal-electrical through-connections (vias) (11), **characterized in that** the metal-filled thermal-electrical through-connections (vias) (11) are filled with Cu and the ceramic flat substrate (6) is aluminum nitride.

2. Circuit according to claim 1, **characterized in that** the Si circuit (4) is a silicon circuit, a chip or a transistor.

3. Circuit according to either claim 1 or claim 2, **characterized in that** all the metallizations (2, 7) consist of DCB-Cu, thick-film Cu, Ag or W-Ni-Au and/or are metallizations sintered together with the ceramic substrate (1, 8).

4. Circuit according to any of claims 1 to 3, **characterized in that** the connecting means (3, 5) is solder, sintered silver or silver adhesive.

5. Circuit according to any of claims 1 to 5, **characterized in that** cooling elements are arranged on the lower face (1a) of the first ceramic substrate (1).

## Revendications

1. Composant (9) constitué d'un premier substrat céramique (1) comportant une face supérieure (1b) et une face inférieure (1a), une métallisation (2), sur laquelle un circuit de commutation Si (4) est monté à l'aide de sa face inférieure par l'intermédiaire d'un agent de liaison (3), étant appliquée sur la face supérieure (1b), un agent de liaison (5) étant appliqué sur la face supérieure du circuit de commutation Si (4), un substrat plat céramique (6) étant appliqué sur l'agent de liaison (5) à l'aide de sa face inférieure, et un second substrat céramique (8) étant disposé sur le substrat plat (6) par l'intermédiaire d'une métallisation (7), et le substrat plat céramique (6) contenant des trous métallisés électrothermiques (vias) (11) remplis de métal, **caractérisé en ce que** les trous métallisés électrothermiques (vias) (11) remplis de métal sont remplis de Cu et **en ce que** le substrat plat céramique (6) est en nitrure d'aluminium.

2. Circuit de commutation selon la revendication 1, **caractérisé en ce que** le circuit de commutation Si (4) est un circuit de commutation en silicium, une puce ou un transistor.

3. Circuit de commutation selon la revendication 1 ou 2, **caractérisé en ce que** toutes les métallisations (2, 7) sont constituées de Cu DCB, de Cu à couche épaisse, d'Ag ou de W-Ni-Au et/ou sont des métallisations frittées avec le substrat céramique (1, 8).

4. Circuit de commutation selon l'une des revendications 1 à 3, **caractérisé en ce que** les agents de liaison (3, 5) sont une brasure, un argent fritté ou une colle à argent.

5. Circuit de commutation selon l'une des revendications 1 à 5, **caractérisé en ce que** des éléments de refroidissement sont disposés sur la face inférieure (1a) du premier substrat céramique (1).
